(19) Europäisches Patentamt / European Patent Office / Office européen des brevets

(11) **EP 3 699 932 A1**

(12) **EUROPEAN PATENT APPLICATION**
published in accordance with Art. 153(4) EPC

(43) Date of publication:
**26.08.2020   Bulletin 2020/35**

(21) Application number: **19747896.9**

(22) Date of filing: **01.02.2019**

(51) Int Cl.:
**H01B 3/30** (2006.01)          **C08L 79/08** (2006.01)
**H01B 3/00** (2006.01)          **H01B 7/02** (2006.01)
**H01B 17/62** (2006.01)          **H05K 1/05** (2006.01)

(86) International application number:
**PCT/JP2019/003650**

(87) International publication number:
**WO 2019/151488 (08.08.2019 Gazette 2019/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority:   **05.02.2018   JP 2018018268**
**28.12.2018   JP 2018246997**

(71) Applicant: **Mitsubishi Materials Corporation**
**Tokyo 100-8117 (JP)**

(72) Inventors:
• **ISHIKAWA, Fumiaki**
**Naka-shi, Ibaraki 311-0102 (JP)**
• **YAMASAKI, Kazuhiko**
**Naka-shi, Ibaraki 311-0102 (JP)**
• **BORDELET, Gabrielle**
**Naka-shi, Ibaraki 311-0102 (JP)**

(74) Representative: **Hoffmann Eitle**
**Patent- und Rechtsanwälte PartmbB**
**Arabellastraße 30**
**81925 München (DE)**

(54) **INSULATING FILM, INSULATED CONDUCTOR, METAL BASE SUBSTRATE**

(57)   An insulating film (10) includes: a resin (11) consisting of a polyimide, a polyamide-imide, or a mixture thereof; and $\alpha$-alumina single crystal particles (12) having an average particle diameter in a range of 0.3 $\mu$m or more and 1.5 $\mu$m or less, in which an amount of the $\alpha$-alumina single crystal particles (12) is in a range of 8% by volume or more and 80% by volume or less. An insulated conductor (20) includes: a conductor (21); and an insulating film provided on a surface of the conductor, in which the insulating film consists of the insulating film (10). A metal base substrate (30) includes a metal substrate (31), an insulating film, and a metal foil (33) which are laminated in this order, in which the insulating film consists of the insulating film (10).

FIG. 1

**Description**

TECHNICAL FIELD

The present invention relates to an insulating film, an insulated conductor, and a metal base substrate in which the insulating film is used.

The present application claims priority on Japanese Patent Application No. 2018-018268 filed on February 5, 2018 and Japanese Patent Application No. 2018-246997 filed on December 28, 2018, the contents of which are incorporated herein by reference.

BACKGROUND ART

Insulating films are used as, for example, an insulating film of an insulated conductor used for a coil and a motor, a protective film for protecting a surface of an electronic component such as a semiconductor chip, an LED element, and the like and a surface of a circuit board, and an insulating film of a metal base substrate.

As an insulating film, a film formed from a resin composition including a resin and an inorganic filler is used. As the resin, resins having high heat resistance, chemical resistance, and mechanical strength, such as polyimide and polyamide-imide, are used.

Along with increasing operating voltages and increasing integration of electronic components in recent years, the amount of heat generated by such electronic components tends to increase, and there is a demand for insulating films having low thermal resistance and high heat dissipation. As a method for reducing the thermal resistance of the insulating film, there is a method of adding an inorganic filler having high thermal conductivity thereto. However, in the case where an inorganic filler having a large particle diameter is added thereto, there is a problem that in the withstand voltage (dielectric breakdown voltage) is decreased (Non-Patent Document 1).

The withstand voltage $V_R$ of the insulating film is expressed by Equation (1), where h is the film thickness of the insulating film and $V_F$ is the withstand voltage per film thickness.

$$V_R = V_F \times h \cdots (1)$$

On the other hand, the thermal resistance R of the insulating film is expressed by Equation (2), where h is the film thickness of the insulating film and $\lambda$ is the thermal conductivity of the insulating film.

$$R \propto h/\lambda \cdots (2)$$

From Equation (1) and Equation (2), it is possible to express the thermal resistance R of the insulating film by Equation (3).

$$R \propto V_R/(\lambda \times V_F) \cdots (3)$$

From Equation (3), it is understood that the thermal resistance R of the insulating film is proportional to the reciprocal of a value of the withstand voltage $V_F$ per film thickness of the insulating film × the thermal conductivity $\lambda$. Accordingly, in order to reduce the thermal resistance R of the insulating film, it is important to increase the value (also referred to below as "performance value") of the withstand voltage $V_F$ per film thickness of the insulating film × the thermal conductivity $\lambda$.

Patent Documents 1 and 2 discloses that nanoparticles are used as an inorganic filler in order to improve the withstand voltage of an insulating film.

Patent Document 1 discloses an insulating film in which nanoparticles having an average maximum diameter of 500 nm or less are used as an inorganic filler. Examples of Patent Document 1 describe insulating films in which 2.5% by mass and 5% by mass of nanoparticles were added respectively.

Patent Document 2 discloses an insulating film which includes a polyamide-imide resin and insulating fine particles having an average primary particle diameter of 200 nm or less. Examples of Patent Document 2 describe an insulating film in which 5% by mass of insulating fine particles were added. However, in general, the thermal conductivity is not greatly improved even in the case where nanoparticles are added to an insulating film.

Patent Documents 3 and 4 describe insulating films which include both nanoparticles and microparticles as inorganic fillers in order to further improve thermal conductivity.

Patent Document 3 discloses a resin composition for an electrical insulating material which includes a first inorganic filler having a microparticle size and a second inorganic filler having a nanoparticle size and consisting of a predetermined material.

Patent Document 4 discloses a resin composition filled with, as inorganic fillers, a thermally conductive inorganic spherical microfiller having a microparticle size, a microfiller having a plate shape, a rod shape, a fiber shape, or a flake shape, and a thermally conductive inorganic nanofiller having a nanoparticle size.

However, as described in Non-Patent Document 1, there is a problem in that the withstand voltage is decreased in the case where microparticles are added to an insulating film.

PRIOR ART DOCUMENTS

Non Patent Document

Non Patent Document 1: Journal of International Council on Electrical Engineering, Vol. 2, No. 1, pp. 90-98, 2012

Patent Document

Patent Document 1: United States Patent Publication No. 2007/0116976
Patent Document 2: Japanese Unexamined Patent Application, First Publication No. 2013-60575
Patent Document 3: Japanese Unexamined Patent Application, First Publication No. 2009-13227
Patent Document 4: Japanese Unexamined Patent Application, First Publication No. 2013-159748

DISCLOSURE OF INVENTION

Problems to be Solved by the Invention

The present invention was made in view of the above-described circumstances, and the present invention aims to provide an insulating film having both a high thermal conductivity and a high voltage endurance (withstand voltage) as well as an excellent heat resistance, chemical resistance, and mechanical properties, an insulated conductor, and a metal base substrate in which this insulating film is used.

Solutions for Solving the Problems

In order to solve the above-described problem, an insulating film of an embodiment of the present invention includes: a resin consisting of a polyimide, a polyamide-imide, or a mixture thereof; and $\alpha$-alumina single crystal particles having an average particle diameter in a range of 0.3 $\mu$m or more and 1.5 $\mu$m or less, in which an amount of the $\alpha$-alumina single crystal particles is in a range of 8% by volume or more and 80% by volume or less.

According to the insulating film having these features, since the resin consists of polyimide, polyamide-imide, or a mixture thereof, the heat resistance, chemical resistance, and mechanical properties are improved.

In addition, since fine $\alpha$-alumina single crystal particles having an average particle diameter in a range of 0.3 $\mu$m or more and 1.5 $\mu$m or less are contained in an amount of 8% by volume or more and 60% by volume or less, it is possible to improve both the withstand voltage and the thermal conductivity without impairing the excellent heat resistance, chemical resistance, and mechanical properties of resins such as polyimide and polyamide-imide.

In the insulating film of the present invention, the amount of the $\alpha$-alumina single crystal particles is preferably in a range of 20% by volume or more and 70% by volume or less. The amount is more preferably in a range of 30% by volume or more and 60% by volume or less.

In such a case, it is possible to more reliably improve both the withstand voltage and the thermal conductivity.

In addition, an insulated conductor of the present invention includes: a conductor; and an insulating film provided on a surface of the conductor, in which the insulating film consists of the above-described insulating film.

According to the insulated conductor having these features, since the insulating film in which both the withstand voltage and the thermal conductivity are improved is provided on the surface of the conductor, the insulated conductor exhibits excellent voltage endurance (withstand voltage) and heat resistance.

In addition, a metal base substrate of the present invention includes a metal substrate, an insulating film, and a metal foil which are laminated in this order, in which the insulating film consists of the above-described insulating film.

According to the metal base substrate having these features, since the insulating film in which both the withstand voltage and the thermal conductivity are improved is disposed between the metal substrate and the metal foil, the metal base substrate exhibits excellent voltage endurance (withstand voltage) and heat resistance.

Effects of Invention

According to the present invention, it is possible to provide an insulating film having both a high thermal conductivity and a high voltage endurance (withstand voltage), as well as an excellent heat resistance, chemical resistance, and mechanical properties, and it is also possible to provide an insulated conductor and a metal base substrate in which this insulating film is used.

BRIEF DESCRIPTION OF DRAWINGS

FIG. 1 is a schematic sectional view of an insulating film according to an embodiment of the present invention.
FIG. 2 is a schematic sectional view of an insulated conductor according to an embodiment of the present invention.
FIG. 3 is a schematic sectional view of a metal base substrate according to an embodiment of the present invention.

EMBODIMENTS FOR CARRYING OUT THE INVENTION

An insulating film, an insulated conductor, and a metal base substrate according to an embodiment of the present invention will be explained below while referring to the accompanying drawings.

(Insulating Film)

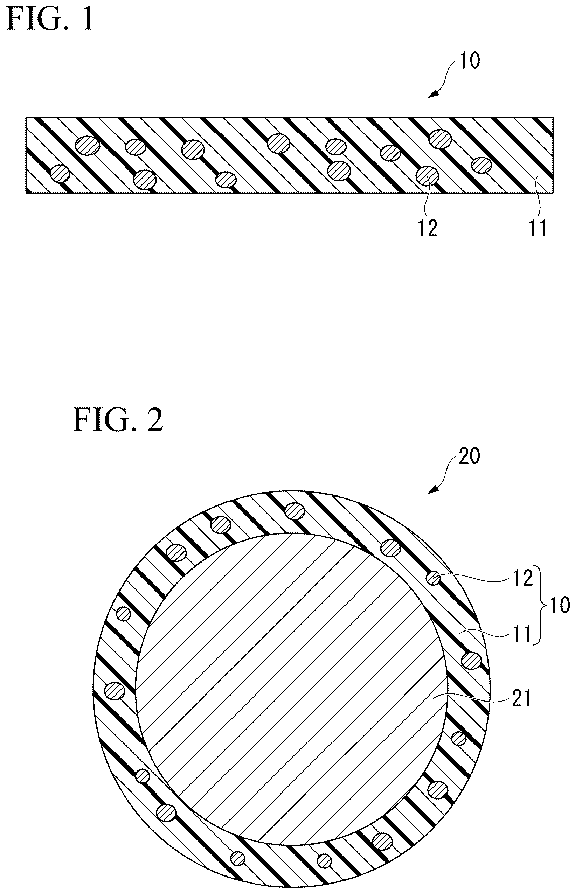

FIG. 1 is a schematic sectional view of an insulating film according to an embodiment of the present invention.
As shown in FIG. 1, an insulating film 10 of the present embodiment includes a resin 11 and $\alpha$-alumina single crystal particles 12.
The resin 11 becomes a base material of the insulating film 10. The resin 11 consists of polyimide, polyamide-imide, or a mixture thereof. Since these resins have imide bonds, the resins have excellent heat resistance, chemical stability, and mechanical properties.
The $\alpha$-alumina single crystal particles 12 have an action of efficiently improving the withstand voltage and the thermal conductivity of the insulating film 10. The $\alpha$-alumina single crystal particles 12 are single crystal particles having a crystal structure of $\alpha$-alumina ($\alpha$-$Al_2O_3$).
It is possible to confirm that the $\alpha$-alumina particles are single crystal particles, for example, as follows.
First, the half width of the peak of the $\alpha$-alumina particles is acquired by the X-ray diffraction method. The acquired half width of the peak is converted into a crystallite diameter (r) according to the Scherrer equation. Separately, the particle diameters of 100 $\alpha$-alumina particles are measured using a scanning electron microscope (SEM) and the average thereof is calculated as the average particle diameter (D). The ratio (r/D) of the crystallite diameter (r) to the calculated average particle diameter (D) of the $\alpha$-alumina particles is calculated, and the particles are regarded as single crystal in the case where the ratio (r/D) is 0.8 or more.
The average particle diameter of the $\alpha$-alumina single crystal particles 12 is in a range of 0.3 $\mu$m or more and 1.5 $\mu$m or less. In the case where the average particle diameter is less than 0.3 $\mu$m, aggregated particles are easily formed, and there is a concern that it may be difficult to uniformly disperse the $\alpha$-alumina single crystal particles 12 in the resin 11. In addition, in the case where the $\alpha$-alumina single crystal particles 12 form aggregated particles, the mechanical strength of the insulating film 10 decreases and the insulating film 10 becomes brittle. On the other hand, in the case where the average particle diameter is more than 1.5 $\mu$m, there is a concern that the withstand voltage of the insulating film 10 may be decreased. The average particle diameter of the $\alpha$-alumina single crystal particles 12 is preferably in a range of 0.3 $\mu$m or more and 0.7 $\mu$m or less.
The average particle diameter of the $\alpha$-alumina single crystal particles 12 is a value of a volume-based cumulative average diameter (Dv50) measured by a laser diffraction type particle size distribution analyzer using a dispersion of the $\alpha$-alumina single crystal particles 12. The dispersion of the $\alpha$-alumina single crystal particles 12 for measuring the average particle diameter can be prepared by, for example, adding the $\alpha$-alumina single crystal particles 12 together with a dispersant to an N-methyl-2-pyrrolidone (NMP) solvent and dispersing the $\alpha$-alumina single crystal particles 12 by ultrasonic dispersion.
As the $\alpha$-alumina single crystal particles 12, for example, it is possible to use AA-03, AA-04, AA-05, AA-07, AA-1.5 of the Advanced Alumina (AA) series sold by Sumitomo Chemical Co., Ltd., and the like.
The amount of the $\alpha$-alumina single crystal particles 12 in the insulating film 10 is in a range of 8% by volume or more and 80% by volume or less. In the case where the amount is less than 8% by volume, there is a concern that it may be difficult to improve the thermal conductivity of the insulating film 10. On the other hand, in the case where the amount is more than 80% by volume, the mechanical strength of the insulating film 10 decreases and the insulating film 10 becomes brittle. In addition, there is a concern that it may be difficult to mix the resin 11 and the α-alumina single crystal particles 12 and it may be difficult to uniformly disperse the α-alumina single crystal particles 12 in the resin 11. From the viewpoint of more reliably improving both the withstand voltage and the thermal conductivity of the insulating film 10, the lower limit of the amount of the α-alumina single crystal particles 12 is preferably 20% by volume or more, and particularly preferably 30% by volume or more. In addition, the upper limit of the amount of α-alumina single crystal particles 12 is preferably 70% by volume or less, and particularly preferably 60% by volume or less.

It is possible to determine the amount of the α-alumina single crystal particles 12 in the insulating film 10, for example, as follows.

The insulating film 10 is heated at 400°C for 12 hours in air to thermally decompose and remove the resin 11, and the remaining α-alumina single crystal particles 12 are recovered. The weight of the recovered α-alumina single crystal particles 12 is measured and the amount (weight basis) (% by weight) of the α-alumina single crystal particles 12 is calculated from the weight of the insulating film 10 before heating. The amount on a weight basis is converted to an amount on a volume basis (% by volume) using the density of the resin and the density of α-alumina.

Specifically, when the weight of the α-alumina particles recovered after heating is Wa (g), the weight of the insulating film before heating is Wf (g), the density of α-alumina is Da (g/cm$^3$), and the density of the resin is Dr (g/cm$^3$), the amount (% by weight) of α-alumina single crystal particles is calculated from the following equation.

$$\text{Amount (\% by weight) of } \alpha\text{-alumina single crystal particles} = \text{Wa/Wf} \times 100$$

$$= \text{Wa/\{Wa + (Wf - Wa)\}} \times 100$$

Next, the amount (% by volume) of α-alumina single crystal particles is calculated by the following equation.

$$\text{Amount (\% by volume) of } \alpha\text{-alumina single crystal particles}$$

$$= (\text{Wa/Da})/\{(\text{Wa/Da}) + (\text{Wf - Wa})/\text{Dr}\} \times 100$$

The film thickness of the insulating film 10 varies depending on the application, but is usually in a range of 1 μm or more and 200 μm or less, and preferably in a range of 10 μm or more and 50 μm or less.

It is possible to use the insulating film 10 of the present embodiment as an insulating film of an insulated conductor used for a coil or a motor as is the case with, for example, an enamel film of an enameled wire. In addition, it is possible to use the insulating film 10 as a protective film for protecting the surface of an electronic component or a circuit board. Furthermore, in a metal base substrate or the like, it is possible to use the insulating film 10 as an insulating film disposed between a metal foil (circuit pattern) and the substrate. In addition, the insulating film 10 is processed into a single sheet or a film, and this sheet or film can be used as, for example, an insulating material for a circuit board such as a flexible printed board and the like.

In the electrodeposition method, an electrodeposition solution including either one of a polyimide or polyamide-imide, a solvent, water, a poor solvent, and a base is electrodeposited on the surface of the conductive substrate to form an electrodeposition film, and then the electrodeposition film is dried, and the obtained dried film is heated and cured.

The insulating film of the present embodiment can be formed by, for example, a coating method or an electrodeposition method.

In the coating method, a resin material consisting of polyimide, polyamide-imide, a precursor thereof, or a mixture thereof is dissolved in a solution, and α-alumina single crystal particles are dispersed in the solution to prepare an α-alumina single crystal particle-dispersed resin solution. Next, the α-alumina single crystal particle-dispersed resin solution is coated on a substrate to form a coated layer. Next, the coated layer is dried and the obtained dried film is heated and cured. As the method of coating the α-alumina single crystal particle-dispersed resin solution on the surface of a metal substrate, it is possible to use a spin coating method, a bar coating method, a knife coating method, a roll coating method, a blade coating method, a die coating method, a gravure coating method, a dip coating method, and the like.

According to the insulating film 10 of the present embodiment having the above-described configuration, since the resin 11 consists of polyimide, polyamide-imide, or a mixture thereof, the heat resistance, chemical resistance, and mechanical properties are improved. In addition, since the fine α-alumina single crystal particles 12 having an average particle diameter in a range of 0.3 μm or more and 1.5 μm or less are contained in an amount of 8% by volume or more and 80% by volume or less, it is possible to improve both the withstand voltage and the thermal conductivity without impairing the excellent heat resistance, chemical resistance, and mechanical properties of resins such as polyimide and polyamide-imide.

In addition, according to the insulating film 10 of the present embodiment, it is possible to more reliably improve both the withstand voltage and the thermal conductivity by setting the amount of the α-alumina single crystal particles 12 to be in a range of 20% by volume or more and 70% by volume or less, and more preferably in a range of 30% by volume or more and 60% by volume or less.

(Insulated Conductor)

Next, an insulated conductor according to an embodiment of the present invention will be explained. Parts where the configuration is the same as that of the above-described insulating film are denoted by the same reference numerals and detailed explanation thereof is omitted.

FIG. 2 is a schematic sectional view of an insulated conductor according to an embodiment of the present invention.

As shown in FIG. 2, the insulated conductor 20 according to the present embodiment includes a conductor 21, and the above-described insulating film 10 provided on the surface of the conductor 21.

The conductor 21 consists of a metal having high conductivity. As the conductor 21, it is possible to use, for example, copper, a copper alloy, aluminum, or an aluminum alloy. In FIG. 2, the cross-section of the conductor 21 is circular, but the cross-section shape of the conductor 21 is not particularly limited, and may be, for example, an ellipse or a square.

The insulating film 10 is a member for insulating the conductor 21 from the outside.

It is possible to manufacture the insulated conductor 20 of the present embodiment by, for example, forming an insulating film on the surface of the conductor by a coating method or an electrodeposition method.

In the insulated conductor 20 of the present embodiment having the above-described configuration, since the insulating film 10 in which both the withstand voltage and the thermal conductivity are improved is provided as an insulating film on the surface of the conductor 21, the insulated conductor 20 exhibits excellent voltage endurance (withstand voltage) and heat resistance.

(Metal Base Substrate)

Next, a metal base substrate according to an embodiment of the present invention will be explained. Parts where the configuration is the same as that of the above-described insulating film are denoted by the same reference numerals and detailed explanation thereof is omitted.

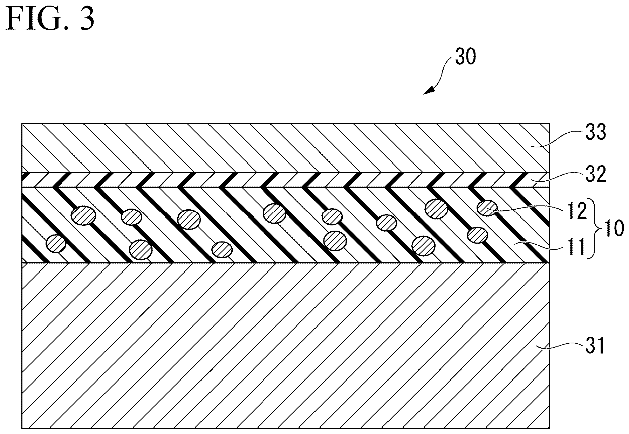

FIG. 3 is a schematic sectional view of a metal base substrate according to an embodiment of the present invention.

As shown in FIG. 3, the metal base substrate 30 of the present embodiment is a laminate in which a metal substrate 31, the above-described insulating film 10, an adhesive layer 32, and a metal foil 33 are laminated in this order.

The metal substrate 31 is a member which is the base of the metal base substrate 30. As the metal substrate 31, it is possible to use a copper plate, an aluminum plate, and laminated plates thereof.

The insulating film 10 is a member for insulating the metal substrate 31 and the metal foil 33.

The adhesive layer 32 is a member provided for improving the adhesion between the insulating film 10 and the metal foil 33.

The adhesive layer 32 preferably includes a resin. As the resin, it is possible to use a silicone resin, an epoxy resin, a polyamide-imide resin, a polyimide resin, or the like. The silicone resin includes a modified silicone resin into which various organic groups are introduced. Examples of the modified silicone resins include polyimide-modified silicone resins, polyester-modified silicone resins, urethane-modified silicone resins, acrylic-modified silicone resins, olefin-modified silicone resins, ether-modified silicone resins, alcohol-modified silicone resins, fluorine-modified silicone resins, amino-modified silicone resins, mercapto-modified silicone resins, and carboxy-modified silicone resins. Examples of the epoxy resins include bisphenol A epoxy resins, bisphenol F epoxy resins, novolak epoxy resins, aliphatic epoxy resins, and glycidylamine epoxy resins. Either one of these resins may be used or a combination of two or more of these resins may be used.

In the adhesive layer 32, inorganic particles may be dispersed in order to improve thermal conductivity. It is possible to use ceramic particles as the inorganic particles. Examples of the ceramic particles include silica particles, alumina particles, boron nitride particles, titanium oxide particles, alumina-doped silica particles, hydrated alumina particles, and aluminum nitride particles.

The metal foil 33 is formed in a circuit pattern. Electronic components are bonded via solder on the metal foil 33 formed in the circuit pattern. As a material of the metal foil 33, it is possible to use copper, aluminum, gold, or the like.

It is possible to manufacture the metal base substrate 30 of the present embodiment by, for example, a method of laminating the insulating film 10 and the adhesive layer 32 on the metal substrate 31 in this order, and then bonding the metal foil 33 on the adhesive layer 32. It is possible to form the insulating film 10 by a coating method or an electrodeposition method. It is possible to form the adhesive layer 32 by, for example, coating a coating liquid for forming an adhesive layer including a resin for forming an adhesive layer, a solvent, and inorganic particles to be added as necessary, on the surface of the insulating film 10 to form a coated layer, and then, heating and drying the coated layer. It is possible to bond the metal foil 33 by overlaying the metal foil 33 on the adhesive layer 32 and then heating the metal foil 33 while applying pressure thereto.

According to the metal base substrate 30 of the present embodiment having the above-described configuration, since the above-described insulating film 10 in which both the withstand voltage and the thermal conductivity are improved is disposed as the insulating film between the metal substrate 31 and the metal foil 33, the metal base substrate 30 exhibits excellent voltage endurance (withstand voltage) and heat resistance.

EXAMPLES

Next, the effects of the present invention will be explained with reference to Examples.

[Invention Examples 1 to 19, Comparative Examples 1 to 8]

An insulating film including inorganic particles and a resin was manufactured using the manufacturing method shown in Table 1. The specific manufacturing method of the insulating film manufactured in each of the Invention Examples and the Comparative Examples was as follows.

<Invention Examples 1 to 11, Comparative Examples 1 to 7>

(Preparation of Polyamic Acid Solution)

A 300 mL separable flask was charged with 4,4'-diaminodiphenyl ether and NMP (N-methyl-2-pyrrolidone). The amount of NMP was adjusted such that the concentration of the obtained polyamic acid was 40% by mass. After stirring at room temperature to completely dissolve the 4,4'-diaminodiphenyl ether, a predetermined amount of tetracarboxylic dianhydride was added little by little such that the internal temperature did not exceed 30°C. Thereafter, stirring was continued for 16 hours under a nitrogen atmosphere to prepare a polyamic acid (polyimide precursor) solution.

(Preparation of Ceramic Particle-Dispersed Polyamic Acid Solution)

Ceramic particles shown in Table 1 below were prepared. 1.0 g of the prepared ceramic particles was added to 10 g of NMP and subjected to ultrasonic treatment for 30 minutes to prepare a ceramic particle dispersion.

Next, the prepared polyamic acid solution, the prepared ceramic particle dispersion, and NMP were mixed such that, finally, the amount of the polyamic acid in the solution was 5% by mass and the amount of the ceramic particles with respect to the total amount of the resin component and the ceramic particles was the volume percentage shown in Table 1 below. Subsequently, the obtained mixture was subjected to a dispersion treatment by repeating a high-pressure injection treatment 10 times at a pressure of 50 MPa, using Starburst manufactured by Sugino Machine Limited, to prepare a ceramic particle-dispersed polyamic acid solution.

(Manufacturing of Insulating Film by Coating Method)

The prepared ceramic particle-dispersed polyamic acid solution was coated on a surface of a copper substrate having a thickness of 0.3 mm and a size of 30 mm × 20 mm such that the film thickness after heating was 20 μm to form a coated layer. Next, the copper substrate on which the coated layer was formed was placed on a hot plate and the temperature was increased from room temperature to 60°C at a temperature increase rate of 3°C/min, heating was carried out at 60°C for 100 minutes, then, the temperature was further increased to 120°C at a temperature increase rate of 1°C/min, and heating was carried out at 120°C for 100 minutes. Thereby, drying was carried out to form a dried film. Thereafter, the dried film was heated at 250°C for 1 minute, and then was heated at 400°C for 1 minute to manufacture a copper substrate with an insulating film.

<Invention Example 12>

A solvent-soluble polyimide and a polyamide-imide were mixed at a weight ratio of 1:1 and the obtained mixture was dissolved in NMP to prepare a mixed solution of a polyimide and a polyamide-imide. A copper substrate with an insulating film was manufactured using a coating method in the same manner as in Invention Example 1, except that the mixed solution, the ceramic particle dispersion, and the NMP were mixed such that, finally, the total amount of the polyimide and the polyamide-imide in the solution was 5% by mass and the amount of the ceramic particles was the amount shown in Table 1 below to prepare a ceramic particle-dispersed resin solution.

<Comparative Example 8>

A heat-curable, one-component, solvent-soluble epoxy resin was prepared. A copper substrate with an insulating film was manufactured using a coating method in the same manner as in Invention Example 1, except that the solvent-soluble epoxy resin, the ceramic dispersion solution, and the NMP were mixed such that, finally, the amount of the epoxy resin in the solution was 8% by mass and the amount of the ceramic particles was the amount shown in Table 1 below to prepare a ceramic particle-dispersed resin solution. The temperature of the coated layer of the ceramic particle-dispersed resin solution was increased from room temperature to 60°C at a temperature increase rate of 3°C/min, heating was carried out at 60°C for 100 minutes, then the temperature was further increased to 120°C at a temperature increase rate of 1°C/min, and heating was carried out at 120°C for 100 minutes. Thereby, drying and curing were carried out to form an insulating film.

<Invention Examples 13 to 19>

(Preparation of Ceramic Particle-Dispersed Resin Solution)

Ceramic particles shown in Table 1 below were prepared. 1.0 g of the prepared ceramic particles was added to a mixed solvent including 62.5 g of NMP, 10 g of 1M2P (1-methoxy-2-propanol), and 0.22 g of AE (amino ether), and the mixture was subjected to an ultrasonic treatment for 30 minutes to prepare a ceramic particle dispersion.
Next, the prepared ceramic particle dispersion was added to 3.3 g of the polyamide-imide solution such that the amount of the ceramic particles with respect to the total amount of the resin component and the ceramic particles was the volume percentage shown in Table 1 below, and thereby, a ceramic particle-dispersed polyamide-imide solution was prepared.

(Preparation of Ceramic Particle-Dispersed Polyamide-imide Electrodeposition Solution)

While stirring the prepared ceramic particle-dispersed polyamide-imide solution at a rotation speed of 5000 rpm, 21 g of water was added dropwise to the ceramic particle-dispersed polyamide-imide solution to prepare a ceramic particle-dispersed polyamide-imide electrodeposition solution.

(Manufacturing of Insulating Film by Electrodeposition Method)

A copper substrate having a thickness of 0.3 mm and a size of 30 mm × 20 mm and a stainless steel electrode were immersed in the prepared electrodeposition solution, and a DC voltage of 100 V was applied using the copper substrate as a positive electrode and the stainless steel electrode as a negative electrode to form an electrodeposition film on the surface of the copper substrate. The back surface of the copper substrate was protected by putting a protective tape thereon such that an electrodeposition film was not formed thereon. The film thickness of the electrodeposition film was adjusted such that the thickness of the insulating film formed by heating was 20 μm. Next, the copper substrate on which the electrodeposition film was formed was heated at 250°C for 3 minutes in an air atmosphere; and thereby, the electrodeposition film was dried to manufacture a copper substrate with an insulating film.

<Evaluation of Copper Substrate with Insulating Film>

The following items were evaluated for the insulating films manufactured in Invention Examples 1 to 19 and Comparative Examples 1 to 8. The results are shown in Table 1.

(Withstand voltage)

The withstand voltage was measured using a multifunctional safety tester 7440 manufactured by Keisoku Giken Co., Ltd. An electrode (Φ6 mm) was disposed on the surface of the insulating film of the copper substrate with an insulating film. The copper substrate of the copper substrate with an insulating film and the electrode disposed on the surface of the insulating film were connected to a power source and the voltage was increased to 6000 V in 30 seconds.

The voltage when the current flowing between the copper substrate and the electrode reached 5000 μA was taken as the withstand voltage of the insulating film.

(Relative Withstand Voltage)

An insulating film consisting of a resin was prepared in the same manner as in Invention Examples 1 to 19 and Comparative Examples 1 to 8 except that the ceramic particles were not dispersed, and the withstand voltage was measured by the above-described method. The withstand voltage of the insulating film of each of Invention Examples 1 to 19 and Comparative Examples 1 to 8 was calculated as a relative withstand voltage with the withstand voltage of the insulating film consisting of the resin being set to 1.

(Thermal Conductivity of Insulating Film)

The thermal conductivity (thermal conductivity in the thickness direction of the insulating film) was measured by a laser flash method using LFA477 Nanoflash manufactured by NETZSCH-Geratebau GmbH. The thermal conductivity was calculated using a two-layer model which did not consider interfacial thermal resistance. The thickness of the copper substrate was set to 0.3 mm as described above and the thermal diffusivity of the copper substrate was set to 117.2 $mm^2$/sec. In order to calculate the thermal conductivity of the insulating film, the density of $\alpha$-alumina particles of 3.89 $g/cm^3$, the specific heat of $\alpha$-alumina particles of 0.78 J/gK, the density of silica particles of 2.2 $g/cm^3$, the specific heat of silica particles of 0.76 J/gK, the density of boron nitride of 2.1 $g/cm^3$, the specific heat of boron nitride of 0.8 J/gK, the density of polyamide-imide resin of 1.41 $g/cm^3$, the specific heat of polyamide-imide resin of 1.09 J/gK, the density of polyimide of 1.4 $g/cm^3$, the specific heat of polyimide of 1.13 J/gK, the density of epoxy resin of 1.2 $g/cm^3$, and the specific heat of epoxy resin of 1.05 J/gK were used.

(Relative Thermal Conductivity)

An insulating film consisting of a resin was prepared in the same manner as in Invention Examples 1 to 19 and Comparative Examples 1 to 8 except that the ceramic particles were not dispersed, and the thermal conductivity was measured by the above-described method. The thermal conductivity of the insulating film of each of Invention Examples 1 to 19 and Comparative Examples 1 to 8 was calculated as a relative thermal conductivity with the thermal conductivity of the insulating film consisting of the resin being set to 1.

(Relative Performance Value)

The value obtained by multiplying the relative withstand voltage and the relative heat conductivity together was calculated as the relative performance value. The larger this value is, the smaller the thermal resistance is.

Table 1

| | No. | Method for manufacturing insulating film | Ceramic particles | | | Resin |
|---|---|---|---|---|---|---|
| | | | Type | Average particle diameter (μm) | Crystal structure | |
| Invention Examples | 1 | Coating method | α-alumina | 0.7 | Single crystal | Polyimide |
| | 2 | Coating method | α-alumina | 0.7 | Single crystal | Polyimide |
| | 3 | Coating method | α-alumina | 0.7 | Single crystal | Polyimide |
| | 4 | Coating method | α-alumina | 0.7 | Single crystal | Polyimide |
| | 5 | Coating method | α-alumina | 0.7 | Single crystal | Polyimide |
| | 6 | Coating method | α-alumina | 0.7 | Single crystal | Polyimide |
| | 7 | Coating method | α-alumina | 0.7 | Single crystal | Polyimide |
| | 8 | Coating method | α-alumina | 0.3 | Single crystal | Polyimide |
| | 9 | Coating method | α-alumina | 0.4 | Single crystal | Polyimide |
| | 10 | Coating method | α-alumina | 0.5 | Single crystal | Polyimide |
| | 11 | Coating method | α-alumina | 1.5 | Single crystal | Polyimide |
| | 12 | Coating method | α-alumina | 0.7 | Single crystal | Mixture of polyimide and polyamide-imide |
| | 13 | Electrodeposition method | α-alumina | 0.7 | Single crystal | Polyamide-imide |
| | 14 | Electrodeposition method | α-alumina | 0.7 | Single crystal | Polyamide-imide |
| | 15 | Electrodeposition method | α-alumina | 0.7 | Single crystal | Polyamide-imide |
| | 16 | Electrodeposition method | α-alumina | 0.7 | Single crystal | Polyamide-imide |
| | 17 | Electrodeposition method | α-alumina | 0.7 | Single crystal | Polyamide-imide |
| | 18 | Electrodeposition method | α-alumina | 0.7 | Single crystal | Polyamide-imide |
| | 19 | Electrodeposition method | α-alumina | 0.7 | Single crystal | Polyamide-imide |

Table 1 (Continued 1)

| | | Method for manufacturing insulating film | Ceramic particles | | | Resin |
| | | | Type | Average particle diameter (μm) | Crystal structure | |
|---|---|---|---|---|---|---|
| Comparative Examples | 1 | Coating method | α-alumina | 0.7 | Polycrystalline | Polyimide |
| | 2 | Coating method | α-alumina | 0.7 | Single crystal | Polyimide |
| | 3 | Coating method | α-alumina | 0.7 | Single crystal | Polyimide |
| | 4 | Coating method | α-alumina | 3 | Single crystal | Polyimide |
| | 5 | Coating method | α-alumina | 18 | Single crystal | Polyimide |
| | 6 | Coating method | Silica | 0.7 | NA | Polyimide |
| | 7 | Coating method | Boron nitride | 0.5 | NA | Polyimide |
| | 8 | Coating method | α-alumina | 0.7 | Single crystal | Epoxy |

Table 1 (Continued 2)

| | | Amount of ceramic particles (% by volume) | Film thickness of insulating film (μm) | Evaluation of insulating film | | | | |
|---|---|---|---|---|---|---|---|---|
| | | | | Withstand voltage (kV) | Relative withstand voltage | Thermal conductivity (W/mK) | Relative thermal conductivity | Relative performance value |
| Invention Examples | 1 | 8 | 20 | 4.5 | 1.1 | 0.6 | 3 | 3.2 |
| | 2 | 10 | 20 | 4.4 | 1.0 | 0.7 | 3.5 | 3.7 |
| | 3 | 20 | 20 | 4.2 | 1.0 | 1.0 | 5 | 5.0 |
| | 4 | 30 | 20 | 4.1 | 1.0 | 1.4 | 7 | 6.8 |
| | 5 | 50 | 20 | 4.0 | 1.0 | 2.0 | 10 | 9.5 |
| | 6 | 70 | 20 | 4.0 | 1.0 | 2.6 | 13 | 12.4 |
| | 7 | 80 | 20 | 3.2 | 0.7 | 1.4 | 7 | 4.9 |
| | 8 | 30 | 20 | 4.3 | 1.0 | 1.2 | 6 | 6.1 |
| | 9 | 30 | 20 | 4.3 | 1.0 | 1.3 | 6.5 | 6.7 |
| | 10 | 30 | 20 | 4.2 | 1.0 | 1.4 | 7 | 7.0 |
| | 11 | 30 | 20 | 3.8 | 0.9 | 1.6 | 8 | 7.2 |
| | 12 | 30 | 20 | 4.1 | 1.0 | 1.4 | 7 | 6.8 |
| | 13 | 8 | 20 | 4.5 | 1.1 | 0.6 | 3 | 3.2 |
| | 14 | 10 | 20 | 4.4 | 1.0 | 0.7 | 3.5 | 3.7 |
| | 15 | 20 | 20 | 4.2 | 1.0 | 1.0 | 5 | 5.0 |
| | 16 | 30 | 20 | 4.1 | 1.0 | 1.4 | 7 | 6.8 |
| | 17 | 50 | 20 | 4.0 | 1.0 | 2.0 | 10 | 9.5 |
| | 18 | 70 | 20 | 4.0 | 1.0 | 2.6 | 13 | 12.4 |
| | 19 | 80 | 20 | 3.2 | 0.7 | 1.4 | 7 | 4.9 |

Table 1 (Continued 3)

| | | Amount of ceramic particles (% by volume) | Film thickness of insulating film (μm) | Evaluation of insulating film | | | | |
|---|---|---|---|---|---|---|---|---|
| | | | | Withstand voltage (kV) | Relative withstand voltage | Thermal conductivity (W/mK) | Relative thermal conductivity | Relative performance value |
| Comparative Examples | 1 | 30 | 20 | 4.1 | 1.0 | 0.6 | 3 | 2.9 |
| | 2 | 4 | 20 | 4.1 | 1.0 | 0.3 | 1.5 | 1.5 |
| | 3 | 85 | 20 | 2.8 | 0.7 | 0.9 | 4.5 | 3.0 |
| | 4 | 30 | 20 | 1.5 | 0.4 | 1.7 | 8.5 | 3.0 |
| | 5 | 30 | 20 | 1.3 | 0.3 | 1.9 | 9.5 | 2.9 |
| | 6 | 30 | 20 | 3.1 | 0.7 | 0.7 | 3.5 | 2.6 |
| | 7 | 30 | 20 | 2.3 | 0.5 | 0.9 | 4.5 | 2.5 |
| | 8 | 30 | 20 | 1.3 | 0.3 | 1.3 | 6.5 | 2.0 |

The insulating film of Comparative Example 1 using polycrystalline particles of $\alpha$-alumina had a low thermal conductivity. The insulating film of Comparative Example 2 in which the added amount of $\alpha$-alumina single crystal particles was smaller than the range of the present invention had a low thermal conductivity. The insulating film of Comparative Example 3 in which the added amount of $\alpha$-alumina single crystal particles was larger than the range of the present invention had a low withstand voltage. The insulating films of Comparative Examples 4 and 5, in which the average particle diameter of $\alpha$-alumina single crystal particles was larger than the range of the present invention, had a low withstand voltage. The insulating film of Comparative Example 6, in which silica nanoparticles were used instead of $\alpha$-alumina single crystal particles, had both a low withstand voltage and a low thermal conductivity. The insulating film of Comparative Example 7, in which boron nitride nanoparticles were used instead of $\alpha$-alumina single crystal particles, had a low withstand voltage. Furthermore, the insulating film of Comparative Example 8 using epoxy resin as the resin had a low withstand voltage; and as a result, the relative performance value was 3 or less which was low.

On the other hand, in the insulating films of Invention Examples 1 to 19, polyimide, polyamide-imide, or a mixture thereof was used as the resin and $\alpha$-alumina single crystal particles having an average particle diameter in a range of 0.3 $\mu$m or more and 1.5 $\mu$m or less were used as the ceramic particles and the amount of $\alpha$-alumina single crystal particles was in a range of 8% by volume or more and 80% by volume or less, and it was confirmed that in the insulating films of Invention Examples 1 to 19, a withstand voltage and a thermal conductivity were improved in a well-balanced manner and a high relative performance value was exhibited. In particular, in the insulating films of Invention Examples 3 to 6, 8 to 12, and 15 to 18, the amount of $\alpha$-alumina single crystal particles was in a range of 20% by volume or more and 70% by volume or less, and it was confirmed that in the insulating films of Invention Examples 3 to 6, 8 to 12, and 15 to 18, a withstand voltage and a thermal conductivity were further improved in a well-balanced manner and a high relative performance value of 5.0 or more was exhibited.

<Invention Example 20>

The ceramic particle-dispersed polyamic acid solution prepared in Invention Example 4 was coated on a release film (Unipeel manufactured by UNITIKA Ltd.) such that the film thickness after drying was 20 $\mu$m to form a coated layer. Next, the release film on which the coated layer was formed was placed on a hot plate, the temperature was increased from room temperature to 60°C at a temperature increase rate of 3°C/min, heating was carried out at 60°C for 100 minutes, then the temperature was further increased to 120°C at a temperature increase rate of 1°C/min, and heating was carried out at 120°C for 100 minutes. Thereby, drying was carried out to form a dried film. Then, after the dried film was peeled off the release film to be a self-supporting film, the dried film was fixed to a stainless steel mold with clips at several portions, and the dried film was heated at 250°C for 1 minute and then heated at 400°C for 1 minute to manufacture a self-supporting insulating film.

With respect to the manufactured self-supporting insulating film, the withstand voltage, the relative withstand voltage, the thermal conductivity, and the relative thermal conductivity were measured, and the performance value was calculated. As a result, the withstand voltage was 4.5 kV, the relative withstand voltage was 1.1, the thermal conductivity was 1.4 w/mK, the relative thermal conductivity was 7, and the performance value was 7.5.

The withstand voltage was measured with the same method as described above, except that electrodes ($\Phi$6 mm) were arranged on both surfaces of the self-supporting insulating film so as to face each other. The thermal conductivity was measured with the same method as described above, except that the thermal conductivity was calculated using a one-layer model.

<Invention Example 21>

It is possible to manufacture the insulated conductor according to Invention Example by coating a conductive wire with an insulating film.

A $\Phi$3 mm copper wire and a stainless steel electrode were immersed in the electrodeposition solution prepared in Invention Example 16 and a DC voltage of 100 V was applied using the copper wire as a positive electrode and the stainless steel electrode as a negative electrode to form an electrodeposition film on the surface of the copper wire. The film thickness of the electrodeposited film was such that the film thickness of the insulating film formed by heating was 20 $\mu$m. Next, the copper wire on which the electrodeposited film was formed was heated at 250°C for 3 minutes in an air atmosphere; and thereby, the electrodeposited film was dried to manufacture a copper wire with an insulating film (insulated copper wire).

<Invention Example 22>

It is possible to manufacture the metal base substrate according to Invention Example by laminating a metal substrate, an insulating film, and a metal foil.

The ceramic particle-dispersed polyamic acid solution prepared in Invention Example 4 was coated on the surface of a copper substrate having a thickness of 1 mm and a size of 20 mm × 20 mm to form a coated layer such that the film thickness after heating was 20 $\mu$m. Next, the copper substrate on which the coated layer was formed was placed on a hot plate, and the temperature was increased from room temperature to 60°C at a temperature increase rate of 3°C/min, heating was carried out at 60°C for 100 minutes, then the temperature was further increased to 120°C at a temperature increase rate of 1°C/min, and heating was carried out at 120°C for 100 minutes; and thereby, drying was carried out to form a dried film. Thereafter, the dried film was heated at 250°C for 1 minute and then heated at 400°C for 1 minute to manufacture a copper substrate with an insulating film. When the thermal conductivity and the withstand voltage of the insulating film of the obtained copper substrate with an insulating film were measured, the thermal conductivity was 1.4 w/mk and the withstand voltage was 4.1 kV.

A protective tape was put on the back surface of the obtained copper substrate with an insulating film, then the copper substrate was immersed in a polyamide-imide solution having a concentration of 25% by mass to form a coated layer of a polyamide-imide solution on the insulating film.

Next, the coated layer was heated at 250°C for 30 minutes to form an adhesive layer on the insulating film.

Next, a copper foil (CF-T4X-SV-18: manufactured by Fukuda Metal Foil & Powder Co., Ltd.) having a thickness of 18 $\mu$m and a width of 1 cm was overlaid on the adhesive layer and then, while a pressure of 5 MPa was applied thereto using a carbon jig, heating was carried out at a temperature of 215°C for 20 minutes in a vacuum to bond the adhesive layer and the copper foil. As described above, a metal base substrate in which the copper substrate, the insulating film, the adhesive layer, and the copper foil were laminated in this order was manufactured.

Industrial Applicability

According to Invention Examples, it is possible to provide an insulating film having both a high thermal conductivity and a high voltage endurance (withstand voltage), as well as an excellent heat resistance, chemical resistance, and mechanical properties, and it is possible to provide an insulated conductor and a metal base substrate in which this insulating film is used.

Explanation of Reference Signs

    10 Insulating film
    11 Resin
    12 $\alpha$-alumina single crystal particles
    20 Insulated conductor
    21 Conductor
    30 Metal base substrate
    31 Metal substrate
    32 Adhesive layer
    33 Metal foil

**Claims**

1. An insulating film comprising:

   a resin consisting of a polyimide, a polyamide-imide, or a mixture thereof; and
   $\alpha$-alumina single crystal particles having an average particle diameter in a range of 0.3 $\mu$m or more and 1.5 $\mu$m or less,
   wherein an amount of the $\alpha$-alumina single crystal particles is in a range of 8% by volume or more and 80% by volume or less.

2. The insulating film according to claim 1,
   wherein the amount of the $\alpha$-alumina single crystal particles is in a range of 20% by volume or more and 70% by volume or less.

3. An insulated conductor comprising:

a conductor; and
an insulating film provided on a surface of the conductor,
wherein the insulating film consists of the insulating film according to claim 1 or 2.

4. A metal base substrate comprising:

a metal substrate;
an insulating film; and
a metal foil, which are laminated in this order,
wherein the insulating film consists of the insulating film according to claim 1 or 2.

FIG. 1

FIG. 2

FIG. 3

## INTERNATIONAL SEARCH REPORT

| International application No. |
| --- |
| PCT/JP2019/003650 |

### A. CLASSIFICATION OF SUBJECT MATTER

Int.Cl. H01B3/30(2006.01)i, C08L79/08(2006.01)i, H01B3/00(2006.01)i, H01B7/02(2006.01)i, H01B17/62(2006.01)i, H05K1/05(2006.01)i

According to International Patent Classification (IPC) or to both national classification and IPC

### B. FIELDS SEARCHED

Minimum documentation searched (classification system followed by classification symbols)
Int.Cl. H01B3/30, C08L79/08, H01B3/00, H01B7/02, H01B17/62, H05K1/05

Documentation searched other than minimum documentation to the extent that such documents are included in the fields searched

| | |
| --- | --- |
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 09-204823 A (SHOWA ELECTRIC WIRE AND CABLE CO., LTD.) 05 August 1997, entire text (Family: none) | 1–4 |
| A | JP 63-052496 A (MITSUBISHI CABLE INDUSTRIES, LTD.) 05 March 1988, entire text (Family: none) | 1–4 |
| A | JP 2014-183300 A (SHINDO DENSHI KOGYO KK) 29 September 2014, entire text (Family: none) | 1–4 |

☒ Further documents are listed in the continuation of Box C. ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 09 April 2019 (09.04.2019) | 23 April 2019 (23.04.2019) |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

International application No.

PCT/JP2019/003650

C (Continuation). DOCUMENTS CONSIDERED TO BE RELEVANT

| Category* | Citation of document, with indication, where appropriate, of the relevant passages | Relevant to claim No. |
|---|---|---|
| A | JP 09-231836 A (GENERAL ELECTRIC CANADA INC.) 05 September 1997, entire text (Family: none) | 1-4 |
| A | JP 2006-134813 A (SUMITOMO ELECTRIC INDUSTRIES, LTD.) 25 May 2006, entire text (Family: none) | 1-4 |
| A | JP 2001-307557 A (HITACHI CABLE, LTD.) 02 November 2001, entire text & US 2003/0232144 A1, entire text & KR 10-2001-0082627 A & CN 1310144 A | 1-4 |
| A | WO 2017/007000 A1 (SUMITOMO SEIKA CHEMICALS CO., LTD.) 12 January 2017, entire text & US 2018/0201804 A1, entire text & EP 3321941 A1 & CA 2991696 A1 & CN 107710339 A & KR 10-2018-0028453 A | 1-4 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018018268 A
- JP 2018246997 A
- US 20070116976 A
- JP 2013060575 A
- JP 2009013227 A
- JP 2013159748 A

**Non-patent literature cited in the description**

- *Journal of International Council on Electrical Engineering,* 2012, vol. 2 (1), 90-98